# EUROPEAN PATENT APPLICATION

(11) **EP 3 054 028 A1**
(43) Date of publication of application: **10.08.2016**
(21) Application number: 16154805.2
(22) Date of filing: 09.02.2016
(51) Int. Cl.: C23C 14/02, C23C 14/16, C23C 14/32, F01D 5/28

(54) **HOT SECTION REPAIR OF METALLIC COATINGS**

(30) Priority: 09.02.2015 US 201514617628
(71) Applicant: United Technologies Corporation, Farmington, CT 06032 (US)
(72) Inventor: UCASZ, Mark T., Middletown, CT Connecticut 06457 (US); SAXTON, Bruce R., West Suffield, CT Connecticut 06093 (US); BALES, Daniel A., Avon, CT Connecticut 06001 (US); BRINDLEY, William J., Hebron, CT Connecticut 06248 (US)
(74) Representative: Gittins, Alex Michael

(57) **Abstract**

Aspects of the disclosure are directed to a servicing of an airfoil of an aircraft engine. A first portion of a first bondcoat layer may be removed from the airfoil while leaving a second portion of the first bondcoat layer intact on the airfoil. A second bondcoat layer may be applied to the airfoil using a coating technique subsequent to the removal of the first portion of the first bondcoat layer.

## Description

### BACKGROUND

In an aircraft environment, an engine that is used to provide thrust to the aircraft may include a turbine that is used to extract energy provided by a combustor for driving a compressor. The turbine typically includes airfoils. The airfoils may have thin walls that are subjected to wear as the engine is operated over a temperature cycle/range.

These airfoils may need to be repaired. Traditionally, a stripping technique is used to remove the entirety of a bondcoat and any diffusion zones/material between the bondcoat and the metal base alloy of the airfoil. Then, a low pressure plasma spraying (LPPS) technique is used to repair/restore the coating. However, application of the stripping technique and LPPS to thin walled airfoils can cause one or both of two conditions: (1) a removal of a portion of the metal base alloy, or (2) an excess of coating (e.g., coating in an amount greater than a threshold) to be deposited onto the airfoil, such that the airfoil has a dimension/thickness that exceeds a tolerable threshold/limit. Either condition may lead to having to scrap, restrip/recoat, or throw away the airfoil.

### BRIEF SUMMARY

The following presents a simplified summary in order to provide a basic understanding of some aspects of the disclosure. The summary is not an extensive overview of the disclosure. It is neither intended to identify key or critical elements of the disclosure nor to delineate the scope of the disclosure. The following summary merely presents some concepts of the disclosure in a simplified form as a prelude to the description below.

Aspects of the disclosure are directed to a method for servicing an airfoil of an aircraft engine, comprising: removing a first portion of a first bondcoat layer from the airfoil while leaving a second portion of the first bondcoat layer intact on the airfoil, and applying a second bondcoat layer to the airfoil using a coating technique subsequent to the removal of the first portion of the first bondcoat layer. In some embodiments, the method further comprises removing a ceramic layer from the airfoil. In some embodiments, the ceramic layer is removed from the airfoil prior to the removal of the first portion of the first bondcoat layer from the airfoil. In some embodiments, the ceramic layer is removed from the airfoil based on an application of a stripping or blasting technique. In some embodiments, the first portion of the first bondcoat layer is removed from the airfoil based on an application of an acid. In some embodiments, the method further comprises removing the application of the acid prior to applying the second bondcoat layer to the airfoil. In some embodiments, the method is applied as part of a scheduled maintenance activity associated with the engine. In some embodiments, the method is applied as part of an unscheduled maintenance activity associated with the engine. In some embodiments, the airfoil comprises a blade associated with a turbine of the engine.

Aspects of the disclosure are directed to an airfoil of an aircraft engine, comprising a first bondcoat layer, and a second bondcoat layer that is applied to the airfoil via a coating technique subsequent to a removal of a first portion of the first bondcoat layer from the airfoil. In some embodiments, the first portion of the first bondcoat layer is removed based on an application of an acid. In some embodiments, the acid is removed prior to the application of the second bondcoat layer to the airfoil. In some embodiments, the second bondcoat layer is applied as part of a scheduled maintenance activity associated with the engine. In some embodiments, the second bondcoat layer is applied as part of an unscheduled maintenance activity associated with the engine. In some embodiments, the airfoil comprises a blade associated with a turbine of the engine.

Aspects of the disclosure are directed to a method for servicing hardware associated with an aircraft engine, comprising: removing a first portion of a first layer from the hardware while leaving a second portion of the first layer intact on the hardware; and applying a second layer to the hardware using a coating technique subsequent to the removal of the first portion of the first layer. In some embodiments, the hardware comprises at least one of a turbine blade, a vane, a seal, a combustor float wall panel, or a nozzle. In some embodiments, at least one of the first layer or the second layer comprises a bondcoat. In some embodiments, at least one of the first layer or the second layer comprises a metallic coating. In some embodiments, the coating technique comprises a cathodic arc technique.

### BRIEF DESCRIPTION OF THE DRAWINGS

The present disclosure is illustrated by way of example and not limited in the accompanying figures in which like reference numerals indicate similar elements.
- FIG. 1: is a side cutaway illustration of a geared turbine engine.
- FIG. 2: illustrates an exemplary cathodic arc apparatus.
- FIG. 3A: illustrates an exemplary airfoil.
- FIG. 3B: illustrates a stack-up of materials of the airfoil of FIG. 3A.
- FIG. 4: illustrates a flowchart of an exemplary method.

### DETAILED DESCRIPTION

It is noted that various connections are set forth between elements in the following description and in the drawings (the contents of which are included in this disclosure by way of reference). It is noted that these connections are general and, unless specified otherwise, may be direct or indirect and that this specification is not intended to be limiting in this respect. A coupling between two or more entities may refer to a direct connection or an indirect connection. An indirect connection may incorporate one or more intervening entities.

In accordance with various aspects of the disclosure, apparatuses, systems and methods are described for manufacturing or repairing one or more components, such as an airfoil of a turbine. In some embodiments, engine parts/components may be stripped of a ceramic and bondcoat (e.g., a low pressure plasma spraying (LPPS) metallic bondcoat) may be partially stripped to remove an oxidized or depleted coating. In some embodiments, a cathodic arc deposition technique may be used to apply a thin coating with correct bondcoat chemistry on top of the partially stripped bondcoat. Aspects of the disclosure may be applied in connection with a metallic coating, potentially in lieu of use or application in connection with a bondcoat.

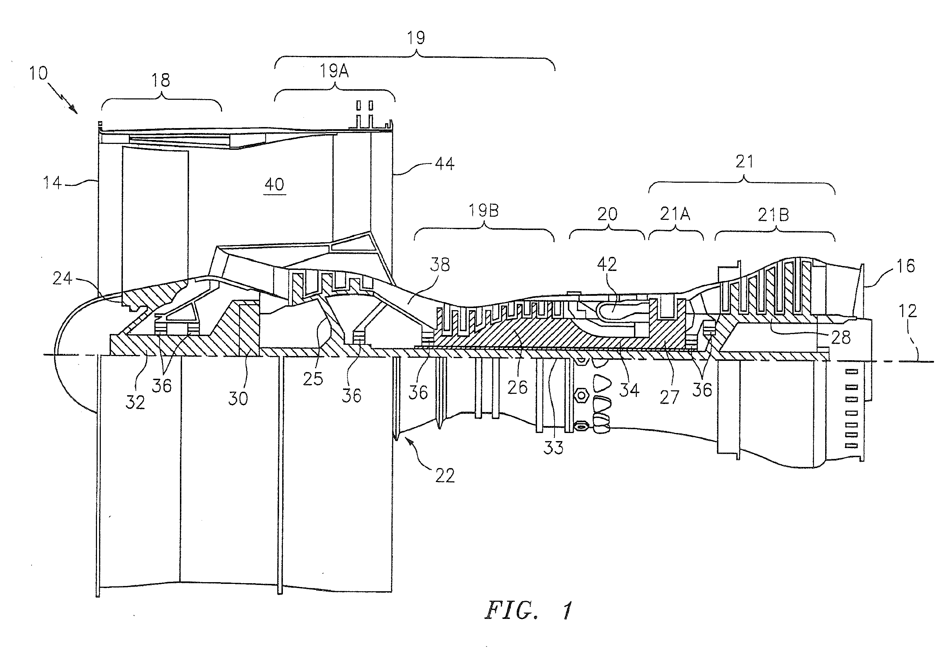

FIG. 1 is a side cutaway illustration of a geared turbine engine 10. This turbine engine 10 extends along an axial centerline 12 between an upstream airflow inlet 14 and a downstream airflow exhaust 16. The turbine engine 10 includes a fan section 18, a compressor section 19, a combustor section 20 and a turbine section 21. The compressor section 19 includes a low pressure compressor (LPC) section 19A and a high pressure compressor (HPC) section 19B. The turbine section 21 includes a high pressure turbine (HPT) section 21A and a low pressure turbine (LPT) section 21B.

The engine sections 18-21 are arranged sequentially along the centerline 12 within an engine housing 22. Each of the engine sections 18-19B, 21A and 21B includes a respective rotor 24-28. Each of these rotors 24-28 includes a plurality of rotor blades arranged circumferentially around and connected to one or more respective rotor disks. The rotor blades, for example, may be formed integral with or mechanically fastened, welded, brazed, adhered and/or otherwise attached to the respective rotor disk(s).

The fan rotor 24 is connected to a gear train 30, for example, through a fan shaft 32. The gear train 30 and the LPC rotor 25 are connected to and driven by the LPT rotor 28 through a low speed shaft 33. The HPC rotor 26 is connected to and driven by the HPT rotor 27 through a high speed shaft 34. The shafts 32-34 are rotatably supported by a plurality of bearings 36; e.g., rolling element and/or thrust bearings. Each of these bearings 36 is connected to the engine housing 22 by at least one stationary structure such as, for example, an annular support strut.

During operation, air enters the turbine engine 10 through the airflow inlet 14, and is directed through the fan section 18 and into a core gas path 38 and a bypass gas path 40. The air within the core gas path 38 may be referred to as "core air". The air within the bypass gas path 40 may be referred to as "bypass air". The core air is directed through the engine sections 19-21, and exits the turbine engine 10 through the airflow exhaust 16 to provide forward engine thrust. Within the combustor section 20, fuel is injected into a combustion chamber 42 and mixed with compressed core air. This fuel-core air mixture is ignited to power the turbine engine 10. The bypass air is directed through the bypass gas path 40 and out of the turbine engine 10 through a bypass nozzle 44 to provide additional forward engine thrust. This additional forward engine thrust may account for a majority (e.g., more than 70 percent) of total engine thrust. Alternatively, at least some of the bypass air may be directed out of the turbine engine 10 through a thrust reverser to provide reverse engine thrust.

The engine 10 is illustrative. Aspects of the disclosure may be applied in connection with other engine types or configurations. For example, aspects of the disclosure may be applied in connection with, e.g., aerospace and non-aerospace turbine engines, such as for example locomotive engines, tank engines, small industrial gas turbines, etc.

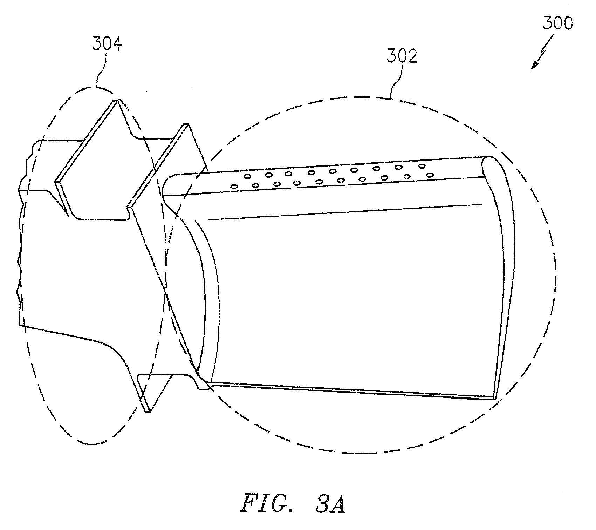

One or more portions of the engine 10, such as the compressor section 19 or the turbine section 21, may include one or more airfoils. An illustrative example of an airfoil 300 is shown in FIG. 3A.

The airfoil 300 may be composed of a first section 302, referred to as a blade. A second section 304 may be configured to attach the airfoil 300 to a rotor of a turbine (e.g., the turbine section 21 of FIG. 1).

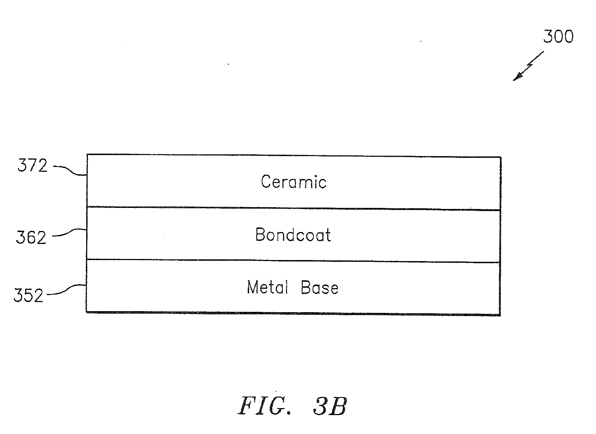

Referring to FIG. 3B, a stack-up of materials associated with at least a portion of the airfoil 300 (e.g., the blade 302) is shown. A metal base layer 352 is coupled to a bondcoat layer 362, which in turn is coupled to a ceramic layer 372.

In some embodiments the bondcoat layer 362 may be approximately 0.001 inches to 0.005 inches thick and the ceramic layer 372 may be approximately 0.0075 inches to 0.125 inches thick. Other values may be used in some embodiments.

FIG. 3B is representative of one potential stack-up of materials that may be used. The bondcoat layer 362 may be used to provide oxidation resistance. In some embodiments, a thermal barrier coating (TBC) may be included to provide thermal protection. In some embodiments, a stack-up may include a base alloy with a metallic layer, which may be representative of stand-alone metallic coatings and under platform coatings. A metallic coating may be used for oxidation/corrosion resistance.

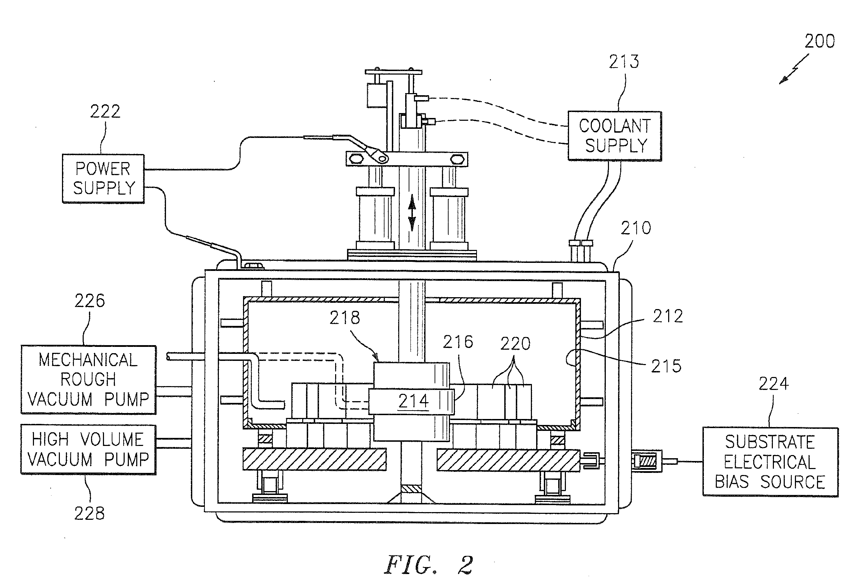

FIG. 2 is a schematic drawing of a cathodic arc apparatus 200. The cathodic arc process occurs within an inner chamber 212, which is surrounded by an outer vacuum chamber 210. A vacuum chamber 210 is provided with fluid cooling via a coolant supply 213. The vacuum chamber 210 has provisions for evacuation to provide a relatively high vacuum environment. A cathode 214 is located relatively centrally in the inner chamber 212. One or more power supplies 222 cause arcing to occur between inner chamber walls 215 and a cylindrical surface 216 of the cathode 214. Assembly 218 may contain an assembly of magnets (not shown), which can be manipulated to influence the arc position and motion. Assembly 218 may provide conductive cooling to the cathode 214. The components 220 (e.g., the airfoil 300) to be coated are located around the cathode 214 with provisions (not shown) to rotate and otherwise manipulate the components 220 so as to promote the formation of a uniform coating on the desired surfaces. In some circumstances the manipulation may be employed to put a coating of controlled, but varying, thickness on a component 220.

The apparatus 200 may include a substrate electrical bias source 224, which may be used to provide an electrical bias to a substrate as part of a cathodic arc deposition technique using the apparatus 200. The apparatus 200 may include a mechanical rough vacuum pump 226 and/or a high volume vacuum pump 228. These pumps 226 and 228 may be associated with the vacuum chamber 210, and their role/function would be understood by one of skill in the art.

The apparatus 200 is illustrative. Other types/configurations of a cathodic arc apparatus may be used in accordance with aspects of the disclosure.

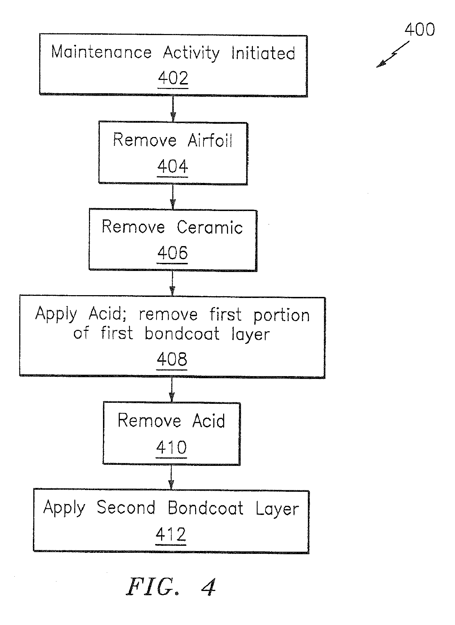

Referring to FIG. 4, a flow chart of a method 400 is shown. The method 400 may be executed by, or applied in connection with, one or more systems, components, or devices, such as the apparatus 200 of FIG. 2 and/or the airfoil 300 of FIGS. 3A-3B.

In block 402, a maintenance activity is initiated. The maintenance activity of block 402 may be a scheduled or unscheduled maintenance activity, and may be associated with an event where an engine (e.g., the engine 10) is disassembled or subject to service.

In block 404, an airfoil (e.g., airfoil 300) may be removed from the engine.

In block 406, a ceramic layer (e.g., ceramic layer 372) may be removed from the airfoil. The removal of the ceramic layer in block 406 may be based on an application of a stripping or blasting technique. In another aspect, the airfoil 300 is obtained from an inventory location and the process starts at step 406.

In block 408, an acid may be applied to the airfoil, or a portion of the airfoil (e.g., the blade 302), to partially remove a first bondcoat layer (e.g., bondcoat layer 362). The amount of removal of the first bondcoat layer may be based on an exposure time of the airfoil to the acid. As a result of block 408, a first portion of the first bondcoat layer may be removed, leaving a second portion of the first bondcoat layer intact.

In block 410, the acid may be removed from the airfoil.

In block 412, a second bondcoat layer may be applied to the airfoil using, e.g., a cathodic arc technique. In some embodiments, a ceramic layer may be reapplied as part of block 412.

The method 400 is illustrative. In some embodiments, one or more of the blocks may be optional. In some embodiments, the blocks may execute in an order or sequence that is different from what is shown. In some embodiments, additional blocks or operations that are not shown may be included.

Aspects of the disclosure may be applied in connection with various types of hardware. For example, aspects of the disclosure may be used to service one or more of a turbine blade, a vane, a seal, a combustor float wall panel, or a nozzle.

While some of the examples described above related to the use of a cathodic arc techniques, aspects of the disclosure may be applied in connection with various types of coating techniques. Such techniques may be used to apply a controlled thin coating.

Some of the examples described above related to a manufacture or repair of hardware. The servicing may apply to new or "engine run" hardware/parts. In some instances, servicing may include a stripping of one or more coatings during original manufacture to rework an improperly applied coating.

Technical effects and benefits of this disclosure include an ability to save engine hardware from undergoing a traditional strip and coat process which would take wall thickness away from the casting and result in scrapped out hardware. Use of a cathodic arc repair technique may be used to restore coating chemistry and coating thickness (of a partially stripped coating) without removing wall thickness from the hardware. Accordingly, a lifetime of a component (e.g., an airfoil, such as a vane or a blade) that is subject to such techniques may be extended.

Aspects of the disclosure have been described in terms of illustrative embodiments thereof. Numerous other embodiments, modifications, and variations within the scope and spirit of the appended claims will occur to persons of ordinary skill in the art from a review of this disclosure. For example, one of ordinary skill in the art will appreciate that the steps described in conjunction with the illustrative figures may be performed in other than the recited order, and that one or more steps illustrated may be optional in accordance with aspects of the disclosure. One or more features described in connection with a first embodiment may be combined with one or more features of one or more additional embodiments.

## Claims

1. A method for servicing an airfoil of an aircraft engine, comprising:
removing a first portion of a first bondcoat layer from the airfoil while leaving a second portion of the first bondcoat layer intact on the airfoil; and
applying a second bondcoat layer to the airfoil using a coating technique subsequent to the removal of the first portion of the first bondcoat layer.

2. The method of claim 1, further comprising:
removing a ceramic layer from the airfoil.

3. The method of claim 2, wherein the ceramic layer is removed from the airfoil prior to the removal of the first portion of the first bondcoat layer from the airfoil.

4. The method of claim 2 or 3, wherein the ceramic layer is removed from the airfoil based on an application of a stripping or blasting technique.

5. The method of any preceding claim, wherein the first portion of the first bondcoat layer is removed from the airfoil based on an application of an acid.

6. The method of claim 5, further comprising:
removing the application of the acid prior to applying the second bondcoat layer to the airfo il.

7. An airfoil of an aircraft engine, comprising:
a first bondcoat layer; and
a second bondcoat layer that is applied to the airfoil via a coating technique subsequent to a removal of a first portion of the first bondcoat layer from the airfoil.

8. The airfoil of claim 7, wherein the first portion of the first bondcoat layer is removed based on an application of an acid.

9. The airfoil of claim 8, wherein the acid is removed prior to the application of the second bondcoat layer to the airfoil.

10. The method of any of claims 1-6, or the airfoil of any of claims 7-9, wherein the method or second bondcoat layer is applied as part of a scheduled maintenance activity associated with the engine.

11. The method of any of claims 1-6, or the airfoil of any of claims 7-9, wherein the method or second bondcoat layer is applied as part of an unscheduled maintenance activity associated with the engine.

12. The method of any of claims 1-6, 10 or 11, or the airfoil of any of claims 7-11, wherein the airfoil comprises a blade associated with a turbine of the engine.

13. A method for servicing hardware associated with an aircraft engine, comprising:
removing a first portion of a first layer from the hardware while leaving a second portion of the first layer intact on the hardware; and
applying a second layer to the hardware using a coating technique subsequent to the removal of the first portion of the first layer;
wherein optionally the hardware comprises at least one of a turbine blade, vane, a seal, a combustor float wall panel, or a nozzle.

14. The method of claim 13, wherein at least one of the first layer or the second layer comprises a bondcoat, and/or at least one of the first layer or the second layer comprises a metallic coating.

15. The method of claim 13 or 14, wherein the coating technique comprises a cathodic arc technique.
